# EUROPÄISCHE PATENTSCHRIFT

(11) **EP 2 239 760 B1**
(45) Veröffentlichungstag und Bekanntmachung des Hinweises auf die Patenterteilung: **28.05.2014**
(21) Anmeldenummer: 10001969.4
(22) Anmeldetag: 26.02.2010
(51) Int. Cl.: H01J 37/32

(54) **Vorrichtung und Verfahren für die plasmagestützte Oberflächenmodifizierung von Substraten im Vakuum**
Device and method for plasma-supported surface modification of substrates in a vacuum
Dispositif et procédé de modification superficielle protégée par plasma de substrats sous vide

(30) Priorität: 19.03.2009 DE 102009015178
(43) Veröffentlichungstag der Anmeldung: 13.10.2010
(73) Patentinhaber: Forschungs- und Applikationslabor Plasmatechnik GmbH Dresden, 01217 Dresden (DE)
(72) Erfinder: Stephan, Ulf, Dr., 01309 Dresden (DE); Kuske, Jürgen, Dr., 1239 Dresden (DE); Steinke, Olaff, Dr., 01219 Dresden (DE)
(74) Vertreter: Pfenning, Meinig & Partner GbR

(56) Entgegenhaltungen:
- EP-A2- 0 961 307
- US-A1- 2003 137 251
- US-A1- 2005 241 768
- RUDIGER J ET AL: "VHF plasma processing for in-line deposition systems" THIN SOLID FILMS, ELSEVIER-SEQUOIA S.A. LAUSANNE, CH LNKD- DOI:10.1016/S0040-6090(02)01174-4, Bd. 427, Nr. 1-2, 3. März 2003 (2003-03-03), Seiten 16-20, XP004417513 ISSN: 0040-6090
- STEPHAN U ET AL: "Problems of power feeding in large area PECVD of amorphous silicon" MATERIALS RESEARCH SOCIETY SYMPOSIUM - PROCEEDINGS 1999 MATERIALS RESEARCH SOCIETY, Bd. 557, 1999, Seiten 157-162, XP002594176

## Beschreibung

Die Erfindung betrifft eine Vorrichtung und Verfahren für die plasmagestützte Oberflächenmodifizierung von Substraten im Vakuum. Sie ist insbesondere für eine Oberflächenmodifizierung großflächiger Substrate geeignet.

Für die Herstellung von Flachbildschirmen oder Solarzellen sollen immer großflächigere Substrate eingesetzt werden, die in Vakuumanlagen an mindestens einer Oberfläche modifiziert werden sollen. Dabei sollen insbesondere Beschichtungen ausgebildet werden.

Hierfür werden ein Plasma und auch geeignete Precursoren eingesetzt. Bei plasmagestützten Verfahren wird elektrische Hochfrequenzspannung eingesetzt, die an zwei Elektroden angeschlossen ist, zwischen denen ein Substrat für die Prozessierung angeordnet ist oder das im Durchlauf durch den Spalt zwischen den Elektroden hindurchgeführt wird. Mit Hilfe des zwischen den Elektroden ausgebildeten elektrischen Feldes kann Plasma generiert und für den Prozess genutzt werden.

Kritisch wird es dabei, da bei großflächigen Substraten das elektrische Feld zwischen den Elektroden über die Fläche inhomogen ist und Bereiche mit höherer elektrischer Feldstärke und kleinerer elektrischer Feldstärke vorhanden sind. Dabei kann beispielsweise die elektrische Feldstärke an den äußeren Rändern groß und im zentralen Bereich klein oder umgekehrt sein.

Dementsprechend steht lokal unterschiedlich Energie für die Plasmagenerierung oder das gebildete Plasma zur Verfügung, was selbstverständlich unerwünscht ist. Die lokale elektrische Feldstärke des zwischen den Elektroden ausgebildeten elektrischen Feldes kann neben der jeweils eingesetzten Frequenz der elektrischen Spannung auch durch die jeweiligen Positionen an denen elektrische Spannung in eine oder beide Elektroden eingespeist wird beeinflusst werden.

Erfolgt die Einspeisung der elektrischen Spannung dabei an vielen Positionen kann eine gleichmäßigere elektrische Feldstärke über die gesamte Fläche zwischen den Elektroden erreicht werden. Dies erhöht aber die Kosten erheblich, da jeweils Vakuumdurchführungen erforderlich sind. Es ist umfangreiche Geräte- und Regelungstechnik erforderlich.

Aus der US 2003/0137251 A1 ist eine Vorrichtung für die Plasmabehandlung, bei der ein Plasma zwischen zwei Elektroden generiert werden soll, bekannt. Eine der Elektroden wird mit mehreren Zuleitungen mit einer elektrischen Hochfrequenzspannung beaufschlagt. Diese Anschlüsse sind auf der Seite der Elektrode angeordnet, die dem generierten Plasma gegenüberliegt. Die Beaufschlagung der Hochfrequenzspannung kann dabei für unterschiedliche Regionen der Elektrode sequenziell erfolgen.

Die US 2005/0241768 A1 betrifft ebenfalls eine solche Vorrichtung. Dabei erfolgt die Versorgung einer aus rohrförmigen Stäben bestehende Elektrode mit elektrischer Hochfrequenzspannung von zwei Seiten über zusätzliche parallel zueinander ausgerichtete, an der Elektrode vorhandene stabförmige Elektroden und über jeweils einen elektrischen Leistungsverteiler an den gegenüberliegenden Seiten. Der Anschluss erfolgt dabei über mehrere Anschlusskontakte. An beiden Seiten wird kontinuierlich eine dynamisch phasenverschobene Hochfrequenzspannung über die Verteiler zugeführt.

Es ist daher Aufgabe der Erfindung eine homogenere Oberflächenmodifizierung bei großflächigen Substraten kostengünstig und mit einfacher Anlagentechnik zu er-reichen.

Erfindungsgemäß wird diese Aufgabe mit einer Vorrichtung, die die Merkmale des Anspruchs 1 aufweist, gelöst. Dabei kann mit einem Verfahren gemäß Anspruch 1 gearbeitet werden.

Vorteilhafte Ausgestaltungen und Weiterbildungen der Erfindung sind bei Anwendung von in untergeordneten Ansprüchen bezeichneten Merkmalen erreichbar.

Bei der Erfindung können an sich herkömmliche Vakuumtechnik und elektrische Hochfrequenztechnik eingesetzt werden, so dass sich im Folgenden auf die erfindungswesentlichen Merkmale konzentriert werden kann.

Bei einer erfindungsgemäßen Vorrichtung sind zwei Elektroden, von denen mindestens eine Elektrode an einen Hochfrequenzspannungsgenerator angeschlossen ist, vorhanden. Die Elektroden weisen dabei in mindestens einer Achsrichtung eine Länge auf, die mindestens so groß wie das 0,25-Fache der Wellenlänge der eingesetzten elektrischen Spannung ist.

An einer Elektrode sind mindestens drei Einspeisungskontakte für elektrische Spannung vorhanden. Zwei Einspeisungskontakte sind in der definierten Achsrichtung mit der größten Länge am äußeren Rand und der mindestens eine weitere Einspeisungskontakt zwischen den beiden Einspeisungskontakten und dabei auf der der anderen Elektrode abgewandten Seite der Elektrode angeordnet.

Von mindestens einem Hochfrequenzspannungsgenerator wird elektrische Spannung alternierend den Einspeisungskontakten oder dem/den weiteren Einspeisungskontakt(en) zugeführt. Da die andere Elektrode auf ein abweichendes elektrisches konstantes Spannungspotential, bevorzugt Erdpotential gelegt ist, bilden sich je nach Einspeisungsposition(en) unterschiedliche elektrische Felder mit entsprechender lokal unterschiedlicher elektrischer Feldstärkeverteilung aus. So ist bei Einspeisung elektrischer Spannung an den äußeren Rändern der Elektrode die elektrische Feldstärke in der Mitte zwischen diesen Einspeisungskontakten, also auch im zentralen Bereich zwischen den Elektroden am größten und wird zu dem äußeren Rand kleiner.

Erfolgt die Einspeisung elektrischer Spannung über den weiteren oder mehrere weitere Einspeisungskontakte, der/die zwischen den an den äußeren Rändern angeordneten Einspeisungskontakten angeordnet ist/sind, ist die Verteilung der elektrischen Feldstärke qualitativ umgekehrt, also an den äußeren Randbereichen größer als im zentralen Bereich.

Bei entsprechend geeigneter Schaltfrequenz und/oder einer Variation des Taktverhältnisses für das Umschalten der Einspeisung elektrischer Spannung zu den verschiedenen Einspeisungskontakten mit den unterschiedlichen Positionen, kann bei der Einkopplung der Energie aus dem elektrischen Feld in die Gasentladung eine homogene Verteilung der elektrischen Leistungsdichte in der Gasentladung zwischen den äußeren Rändern der Elektrode bzw. den dort angeordneten Einspeisungskontakten erreicht werden, da sowohl eine Zeitkonstante bei der Rekombination der Ladungsträger in der Gasentladung als auch im zeitlichen Mittel (integral) eine Addition der Leistungsverteilung bei den beiden alternierend durchgeführten Einspeisungen ausgenutzt werden kann.

Bevorzugt sind zwei Einspeisungskontakte am äußeren Rand auf der mittleren Längsachse der Elektrode und der eine weitere Einspeisungskontakt im Flächenschwerpunkt an der der anderen Elektrode abgewandten Seite der Elektrode angeordnet.

Die Länge der Elektroden in der Achsrichtung und/oder der Abstand der Einspeisungskontakte am äußeren Rand sollte vorzugsweise so groß, wie das 0,5-Fache der Wellenlänge der eingespeisten elektrischen Spannung sein. Dabei soll hier immer unter der Achsrichtung, die vorab über die mindestens 0,25-Fache Wellenlänge der elektrischen Spannung definierte verstanden werden.

Günstig ist es außerdem, wenn die Länge der Elektroden in der Achsrichtung bzw. der Abstand der am äußeren Rand angeordneten Einspeisungskontakte größer als die Länge eines zu modifizierenden Substrates in der Achsrichtung ist.

Ein Hochfrequenzgenerator kann durch einen Umschalter alternierend zwischen den am Rand der einen Elektrode angeordneten Einspeisungskontakten und dem/den weiteren dazwischen und an der der anderen Elektrode abgewandten Seite der Elektrode (Rückseite) angeordneten Einspeisungskontakt(en) umgeschaltet werden.

Alternativ ist es auch möglich, dass ein Signalgenerator durch einen Umschalter alternierend an einen von zwei Leistungsverstärkern geschaltet werden kann, wobei ein Leistungsverstärker beide Einspeisungen zu an den am Rand der Elektrode angeordneten Einspeisungskontakten und der andere die Einspeisung zu dem mindestens einen weiteren zwischen den am Rand angeordneten Einspeisungskontakten angeordneten Einspeisungskontakt realisiert.

Bei Einsatz der Erfindung ist es günstig, die Länge der Elektroden mindestens zweifach größer als die Breite der Elektroden zu wählen. Bei einer deutlich größeren Länge von Elektroden in der Achsrichtung, in Bezug zur senkrecht dazu ausgerichteten Breite, wirkt sich die Erfindung besser aus. Für eine Modifizierung von Substraten, die in einer Achsrichtung senkrecht dazu breiter sind, können daher auch mehrere parallel dazu ausgerichtete und erfindungsgemäß ausgebildete sowie betriebene Elektrodenpaare eingesetzt werden.

Bei einer Länge von Elektroden in der Achsrichtung, die dem 0,5-Fachen der Wellenlänge der eingesetzten elektrischen Spannung entspricht, können die besten Ergebnisse erreicht und die beste homogene Verteilung der Leistungsdichte in der Gasentladung über die Fläche und im Zeitmittel erreicht werden.

Liegt die Länge der Elektroden in der Achsrichtung über dem 0,5-Fachen der Wellenlänge der Anregungsfrequenz, so können Verbesserungen mit mehr als einem weiteren Einspeisungskontakt, die zwischen den beiden am äußeren Rand angeordneten Einspeisungskontakten auf der der anderen Elektrode abgewandten Elektrodenseite angeordnet sein sollen, erreicht werden. Dabei können diese einmal äquidistant zueinander und ggf. auch zu den am Rand angeordneten Einspeisungskontakten angeordnet sein.

Es ist auch möglich die am äußeren Rand der Elektrode angeordneten Einspeisungskontakte in diesem Randbereich, aber ebenfalls auf der der zweiten Elektrode abgewandten Seite der Elektrode, an der auch der/die weitere(n) Einspeisungskontakt(e) angeordnet ist/sind, anzuordnen. Ihre Positionen befinden sich dann in einem jedoch kleinen Abstand z.B. von wenigen Millimetern bzw. Zentimetern zum tatsächlichen Rand mit den dortigen Stirnkanten. Dadurch können Spitzen elektrischer Feldstärke, die durch Hohlleitermoden auftreten können, in diesem äußeren Randbereich und auch dem Bereich der eigentlich für eine Substratmodifizierung nicht genutzt werden sollte oder auch konnte, vermieden werden.

Erfindungsgemäß erfolgt eine Einspeisung von elektrischer Hochfrequenzspannung alternierend d.h. abwechselnd also entweder an den am äußeren Rand in der Achsrichtung angeordneten Einspeisungskontakten oder dem mindestens einen weiteren Einspeisungskontakt bzw. mehr als einen zwischen den am äußeren Rand angeordneten Einspeisungskontakten, der/die auf der der zweiten Elektrode abgewandten Seite der Elektrode angeordnet ist/sind, in die erste Elektrode.

Dabei kann die Einschaltzeit für die Einspeisung elektrischer Spannung über die Einspeisungskontakte an den Rändern und dem/den weiteren Einspeisungskontakt(en), der/die auf der der anderen Elektrode abgewandten Elektrodenseite angeordnet ist/sind jeweils gleich groß gehalten oder variiert werden.

Es ist auch möglich, die Amplitude der elektrischen Spannung die jeweils über die beiden Einspeisungskontakte an den äußeren Rändern und den/die an der der anderen Elektrode abgewandten Seite der Elektrode angeordneten Einspeisungskontakt(en) zu variieren/regeln. Dabei kann die Amplitude mit der die elektrische Spannung über die am äußeren Rand angeordneten Einspeisungskontakte eingespeist wird von der Amplitude, mit der elektrische Spannung über den einen oder mehrere weitere Einspeisungskontakte der Elektrode zugeführt wird, abweichen. Dadurch kann die Homogenität der integralen Leistungsdichte über die Gesamtfläche zwischen den beiden Elektroden optimiert werden.

Nachfolgend soll die Erfindung beispielhaft näher erläutert werden.

Dabei zeigen:
Figur 1 in schematischer Form ein Beispiel einer erfindungsgemäßen Vorrichtung mit drei Einspeisungskontakten und
Figur 2 in schematischer Form ein zweites Beispiel einer erfindungsgemäßen Vorrichtung.

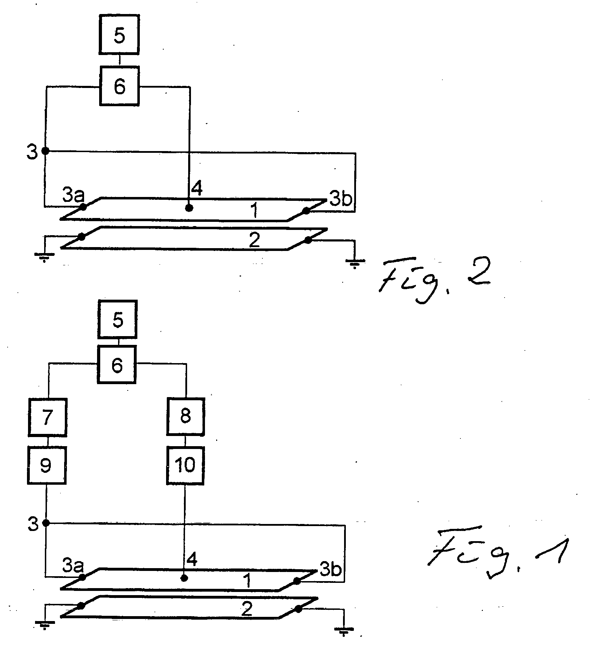

Das in Figur 1 gezeigte Beispiel einer erfindungsgemäßen Vorrichtung ist hier mit drei Einspeisungskontakten 3a, 3b und 4 versehen worden. In Figur 1 ist auf die Darstellung von Komponenten einer Vakuumbeschichtungs- bzw. -modifizierungsanlage, wie z.B. die Vakuumtechnik, mindestens ein Substrat und technische Elemente für eine Gaszu-, abfuhr, den Transport von Substraten u.a.m. verzichtet worden.

Bei diesem Beispiel sind zwei plattenförmige Elektroden 1 und 2 vorhanden, die in einem über die gesamte Fläche konstanten Abstand, also hier parallel zueinander angeordnet sind. Die zweite Elektrode 2 ist an Erdpotential angeschlossen.

An der hier oben dargestellten ersten Elektrode 1 sind an deren äußeren Rändern an der längeren Seite zwei Einspeisungskontakte 3a und 3b vorhanden. Der Dritte, hier als einziger weiterer Einspeisungskontakt 4, ist auf der der Elektrode 2 abgewandten Seite und mittig zwischen den beiden anderen Einspeisungskontakten 3a und 3b angeordnet.

Die elektrische Hochfrequenzspannung wird von einem Hochfrequenzgenerator 5 zur Verfügung gestellt. Mit dem zwischengeschalteten Umschalter 6 kann elektrische Spannung entweder über die Einspeisungskontakte 3a und 3b oder den weitern Einspeisungskontakt 4 in die Elektrode 1 eingespeist werden. Entsprechend dem in Figur 1 gezeigten Beispiel ist es auch möglich einen Signalgenerator 5 einzusetzen und zwischen dem Umschalter 6 und den zwei Kreisen für die Einspeisung elektrischer Spannung sind jeweils eine Anpassungseinheit (Matchbox) 9 und 10 sowie Leistungsverstärker 7 und 8 zu schalten, über die eine Einspeisung elektrischer Spannung in die Elektrode 1 erfolgt.

Wird elektrische Spannung über die beiden Einspeisungskontakte 3a und 3b zugeführt, bildet sich zwischen den beiden Elektroden 1 und 2 ein elektrisches Feld aus, dessen elektrische Feldstärke in der Mitte zwischen den Einspeisungskontakten 3a und 3b am größten ist.

Wird dann mit dem Umschalter 6 umgeschaltet und elektrische Spannung nur über den weiteren Einspeisungskontakt 4 zugeführt, bildet sich ein elektrisches Feld zwischen den beiden Elektroden 1 und 2 aus, dessen elektrische Feldstärke an den äußeren Rändern, also dort wo die Einspeisungskontakte 3a und 3b angeordnet sind, am größten ist.

Bei geeigneter Umschaltfrequenz für das Einspeisen elektrischer Spannung in die Einspeisungskontakte 3a und 3b bzw. 4 der Elektrode 1 kann bei der Einkopplung der Energie aus dem elektrischen Feld in eine Gasentladung über die Zeit eine homogene Verteilung der elektrischen Leistungsdichte in der Gasentladung zumindest über die Länge der Elektroden 1 und 2 bzw. zwischen den Einspeisungskontakten 3a und 3b erreicht werden. Durch eine Variation des Taktverhältnisses der Einspeisung elektrischer Spannung über die Einspeisungskontakte 3a und 3b bzw. den Einspeisungskontakt 4 kann eine Optimierung erreicht werden.

Das in Figur 1 gezeigte Beispiel kann wie folgt dimensioniert sein und betrieben werden:
Die Länge der Elektrode 1 und 2 lag bei 1600 mm und die Breite bei 300 mm. Damit können mit einer parallelen Anordnung von vier Elektrodenpaaren üblicherweise eingesetzte Substrate mit Abmessungen von 1400 mm * 1100 mm ohne weiteres prozessiert werden. Der Abstand der Elektroden 1 und 2 lag bei 10 mm.
Die Einspeisung der elektrischen Spannung erfolgte mit einer Frequenz von 93,7 MHz. Dies ergibt eine Wellenlänge von 3200 mm im Vakuum. Der Fehler der Leistungsverteilung konnte auf ± 4,7% begrenzt werden. Dabei wurde ein Taktverhältnis für eine Einspeisung über die Einspeisungskontakte 3a und 3b oder den Einspeisungskontakt 4 von 1 : 1 eingehalten.
Figur 2 zeigt ein Beispiel bei dem elektrische Spannung von einem Hochfrequenzgenerator 5 über einen Umschalter 6 entweder den Einspeisungskontakten 3a und 3b oder dem Einspeisungskontakt 4 zuführt.

## Patentansprüche

1. Vorrichtung für die plasmagestützte Oberflächenmodifizierung von Substraten im Vakuum, mit zwei Elektroden, von denen mindestens eine Elektrode an einen Hochfrequenzspannungsgenerator angeschlossen ist, wobei an dieser Elektrode (1) mindestens drei Einspeisungskontakte (3a, 3b und 4) für elektrische Spannung vorhanden sind und von mindestens einem Hochfrequenzspannungsgenerator (5) elektrische Spannung alternierend den Einspeisungskontakten (3a und 3b) oder dem Einspeisungskontakt (4) zuführbar ist,
***dadurch gekennzeichnet, dass***
die Elektroden (1, 2) in mindestens der Achsrichtung mit der größten Länge eine Länge aufweisen, die mindestens so groß wie das 0,25-Fache der Wellenlänge der elektrischen Spannung ist, und zwei Einspeisungskontakte (3a, 3b) in der Achsrichtung am äußeren Rand oder diesem Randbereich angeordnet sind und der mindestens eine weitere Einspeisungskontakt (4) zwischen den beiden Einspeisungskontakten (3a und 3b) und auf der der anderen Elektrode (2) abgewandten Seite der Elektrode (1) angeordnet ist.

2. Vorrichtung nach Anspruch 1, **dadurch gekennzeichnet, dass** die zwei Einspeisungskontakte (3a und 3b) auf der mittleren Längsachse der Elektrode (1) und der weitere Einspeisungskontakt (4) im Flächenschwerpunkt der Elektrode (1) angeordnet sind.

3. Vorrichtung nach Anspruch 1 oder 2, **dadurch gekennzeichnet, dass** die Länge der Elektroden (1, 2) in der Achsrichtung und/oder der Abstand der Einspeisungskontakte (3a, 3b) mindestens so groß, wie das 0,25-Fache der Wellenlänge der eingespeisten elektrischen Spannung ist.

4. Vorrichtung nach einem der vorhergehenden Ansprüche, **dadurch gekennzeichnet, dass** die Länge der Elektroden (1, 2) in der Achsrichtung mindestens so groß, wie die Länge eines zu modifizierenden Substrates in der Achsrichtung ist.

5. Vorrichtung nach einem der vorhergehenden Ansprüche, **dadurch gekennzeichnet, dass** zwischen einem Hochspannungsfrequenzgenerator (5) und den Einspeisungskontakten (3a, 3b) und dem weiteren Einspeisungskontakt (4) ein Umschalter (6) geschaltet ist.

6. Vorrichtung nach einem der vorhergehenden Ansprüche, **dadurch gekennzeichnet, dass** die Länge der Elektroden (1, 2) mindestens zweifach größer als die Breite der Elektroden (1, 2) ist.

7. Vorrichtung nach einem der vorhergehenden Ansprüche, **dadurch gekennzeichnet, dass** bei einer Länge der Elektroden (1, 2) in der Achsrichtung, die größer als das 0,5-Fache der Wellenlänge der elektrischen Spannung ist, mehr als ein Einspeisungskontakt (4) auf der der Elektrode (2) abgewandten Seite der Elektrode (1) zwischen den Einspeisungskontakten (3a und 3b) angeordnet ist.

8. Verfahren zur plasmagestützten Oberflächenmodifizierung von Substraten im Vakuum mit einer Vorrichtung nach einem der vorhergehenden Ansprüche, **dadurch gekennzeichnet, dass** eine Einspeisung von elektrischer Hochfrequenzspannung alternierend über die Einspeisungskontakte (3a und 3b) und den mindestens einen weiteren Einspeisungskontakt (4) in die Elektrode (1) durchgeführt wird.

9. Verfahren nach Anspruch 8, **dadurch gekennzeichnet, dass** die Einschaltzeit für die Einspeisung elektrischer Spannung über die Einspeisungskontakte (3a, und 3b) und den/die weiteren Einspeisungskontakt(e) (4) variiert wird.

10. Verfahren nach Anspruch 8 oder 9, **dadurch gekennzeichnet, dass** die Amplituden der elektrischen Spannung an den Einspeisungskontakten (3a, 3b und 4) und dadurch die elektrische Feldstärke zwischen den beiden Elektroden (1, 2) eingestellt wird.

## Claims

1. A device for the plasma-supported surface modification of substrates in a vacuum, having two electrodes, of which at least one electrode is connected to a high-frequency voltage generator, wherein at least three feed contacts (3a, 3b and 4) for electrical voltage are provided on this electrode (1) and electrical voltage may be supplied in alternating manner from at least one high-frequency voltage generator (5) to the feed contacts (3a and 3b) or the feed contact (4),
**characterised in that**
the electrodes (1, 2) have, at least in the axial direction having the greatest length, a length that is at least as great as 0.25 times the wavelength of the electrical voltage, and two feed contacts (3a, 3b) are arranged in the axial direction on the outer edge or in this edge region and the at least one further feed contact (4) is arranged between the two feed contacts (3a and 3b) and on the side of the electrode (1) remote from the other electrode (2).

2. A device according to Claim 1, **characterised in that** the two feed contacts (3a and 3b) are arranged on the centre longitudinal axis of the electrode (1) and the further feed contact (4) is arranged at the centroid of the electrode (1).

3. A device according to Claim 1 or 2, **characterised in that** the length of the electrodes (1, 2) in the axial direction and/or the spacing between the feed contacts (3a, 3b) is at least as great as 0.25 times the wavelength of the electrical voltage that is fed in.

4. A device according to one of the preceding claims, **characterised in that** the length of the electrodes (1, 2) in the axial direction is at least as great as the length in the axial direction of a substrate to be modified.

5. A device according to one of the preceding claims, **characterised in that** a change-over switch (6) is connected between a high-voltage frequency generator (5) and the feed contacts (3a, 3b) and the further feed contact (4).

6. A device according to one of the preceding claims, **characterised in that** the length of the electrodes (1, 2) is at least twice as great as the width of the electrodes (1, 2).

7. A device according to one of the preceding claims, **characterised in that** if the length of the electrodes (1, 2) in the axial direction is greater than 0.5 times the wavelength of the electrical voltage, more than one feed contact (4) is arranged between the feed contacts (3a and 3b), on the side of the electrode (1) remote from the electrode (2).

8. A method for the plasma-supported surface modification of substrates in a vacuum, having a device according to one of the preceding claims, **characterised in that** electrical high-frequency voltage is fed in alternating manner to the electrode (1) by way of the feed contacts (3a and 3b) and the at least one further feed contact (4).

9. A method according to Claim 8, **characterised in that** the switch-on period for feeding electrical voltage by way of the feed contacts (3a, and 3b) and the further feed contact(s) (4) is varied.

10. A method according to Claim 8 or 9, **characterised in that** the amplitudes of the electrical voltage at the feed contacts (3a, 3b and 4) and hence the electrical field strength between the two electrodes (1, 2) are adjusted.

## Revendications

1. Dispositif pour la modification de surfaces par plasma de substrats dans le vide, présentant deux électrodes, dont au moins une électrode est branchée à un générateur de tension haute fréquence, au moins trois contacts d'alimentation (3a, 3b et 4) pour la tension électrique étant présents sur cette électrode (1) et une tension électrique pouvant être appliquée par au moins un générateur de tension haute fréquence (5) alternativement aux contacts d'alimentation (3a et 3b) ou au contact d'alimentation (4),
**caractérisé en ce que**
les électrodes (1, 2) présentent, au moins dans la direction axiale avec la plus grande longueur, une longueur qui est au moins égale à 0,25 fois la longueur d'onde de la tension électrique, et deux contacts d'alimentation (3a, 3b) sont disposés dans la direction axiale sur le bord externe ou sur cette zone de bord, et l'au moins un autre contact d'alimentation (4) est disposé entre les deux contacts d'alimentation (3a et 3b) et sur le côté de l'électrode (1) opposé à l'autre électrode (2).

2. Dispositif selon la revendication 1, **caractérisé en ce que** les deux contacts d'alimentation (3a et 3b) sont disposés sur l'axe longitudinal central de l'électrode (1) et l'autre contact d'alimentation (4) au niveau du centre de gravité de la surface de l'électrode (1).

3. Dispositif selon la revendication 1 ou 2, **caractérisé en ce que** la longueur des électrodes (1, 2) dans la direction axiale et/ou la distance entre les contacts d'alimentation (3a, 3b) est au moins égale à 0,25 fois la longueur d'onde de la tension électrique appliquée.

4. Dispositif selon l'une des revendications précédentes, **caractérisé en ce que** la longueur des électrodes (1, 2) dans la direction axiale est au moins égale à la longueur d'un substrat à modifier dans la direction axiale.

5. Dispositif selon l'une des revendications précédentes, **caractérisé en ce que**, entre un générateur de tension haute fréquence (5) et les contacts d'alimentation (3a, 3b) et l'autre contact d'alimentation (4), est branché un commutateur (6).

6. Dispositif selon l'une des revendications précédentes, **caractérisé en ce que** la longueur des électrodes (1, 2) est au moins deux fois plus grande que la largeur des électrodes (1, 2).

7. Dispositif selon l'une des revendications précédentes, **caractérisé en ce que**, dans le cas d'une longueur des électrodes (1, 2) dans la direction axiale supérieure à 0,5 fois la longueur d'onde de la tension électrique, plus d'un contact d'alimentation (4) est disposé sur le côté de l'électrode (1) opposé à l'électrode (2), entre les contacts d'alimentation (3a et 3b).

8. Procédé de modification de surfaces par plasma des substrats dans le vide avec un dispositif selon l'une des revendications précédentes, **caractérisé en ce qu'**une alimentation de tension électrique haute fréquence est effectuée alternativement par l'intermédiaire des contacts d'alimentation (3a et 3b) et de l'au moins un autre contact d'alimentation (4) dans l'électrode (1).

9. Procédé selon la revendication 8, **caractérisé en ce que** le temps de mise en marche pour l'alimentation en tension électrique est modifié par l'intermédiaire des contacts d'alimentation (3a et 3b) et du(des) contacts(s) d'alimentation (4).

10. Procédé selon la revendication 8 ou 9, **caractérisé en ce que** les amplitudes de la tension électrique au niveau des contacts d'alimentation (3a, 3b et 4) et donc l'intensité du champ électrique entre les deux électrodes (1, 2) sont ajustées.
